# FASCICULE DE BREVET EUROPEEN

(11) **EP 1 177 581 B1**
(45) Date de publication et mention de la délivrance du brevet: **06.05.2015**
(21) Numéro de dépôt: 99932962.6
(22) Date de dépôt: 23.07.1999
(51) Int. Cl.: H01L 27/146, G01T 1/20, H01L 31/0216

(54) **DETECTEUR DE RAYONNEMENT A L'ETAT SOLIDE A DUREE DE VIE ACCRUE**
FESTKÖRPER-STRAHLUNGSDETEKTOR MIT VERLÄNGERTER LEBENSDAUER
SOLID-STATE PHOTODETECTOR WITH INCREASED LIFETIME

(30) Priorité: 11.08.1998 FR 9810305
(43) Date de publication de la demande: 06.02.2002
(73) Titulaire: Trixell S.A.S., 38430 Moirans (FR)
(72) Inventeur: MOY, Jean-Pierre, Thomson-CSF P.I. Dépt. Brevets, 94117 Arcueil Cedex (FR); VIEUX, Gérard; Thomson-CSF P.I. Dépt. Brevets, 94117 Arcueil Cedex (FR); MONIN, Didier, Thomson-CSF P.I. Dépt. Brevets, 94117 Arcueil Cedex (FR); FERON, Odile, Thomson-CSF P.I.Dépt. Brevets, 94117 Arcueil Cedex (FR)
(74) Mandataire: Guérin, Michel
(86) Numéro de dépôt international: PCT/FR1999/001817
(87) Numéro de publication internationale: WO 2000/010194

(56) Documents cités:
- EP-A- 0 528 676
- EP-A- 0 637 084
- FR-A- 2 758 654
- US-A- 5 187 369
- Grovenor, C.R.M.: "Microelectronic Materials", 1989, IOP Publishing Ltd, Bristol UK ISBN: 085274269X page 291, * General statement on passivation. *

## Description

La présente invention concerne les détecteurs de rayonnement à l'état solide de type comportant un capteur photosensible formé d'une pluralité d'éléments photosensibles à l'état solide, associé à un convertisseur de rayonnement. Le convertisseur convertit le rayonnement qu'il reçoit de manière à ce qu'il puisse être exploité par le capteur. Le domaine d'utilisation de ce type de détecteur est notamment la radiologie médicale.

Le capteur photosensible à l'état solide ne réagit pas aux longueurs d'ondes très courtes, comme les rayons X par exemple. Dans cette application, le convertisseur de rayonnement est un écran scintillateur qui est réalisé dans une substance qui a la propriété, lorsqu'elle est excitée par des rayons X, d'émettre dans une gamme de longueurs d'onde plus grandes : dans le visible ou le proche visible.

La lumière visible ainsi générée est transmise aux éléments photosensibles du capteur qui effectuent une conversion photoélectrique de l'énergie lumineuse reçue en signaux électriques exploitables par des circuits électroniques appropriés.

Dans d'autres applications le convertisseur peut être un écran fluorescent et convertir un rayonnement visible ou proche du visible en un rayonnement visible.

Le convertisseur peut ainsi par exemple convertir un rayonnement ultraviolet en un rayonnement visible auquel sont sensibles les éléments photosensibles du capteur. D'autres convertisseurs reçoivent un rayonnement infrarouge qu'ils convertissent en rayonnement visible.

Les éléments photosensibles sont réalisés à partir de matériaux semi-conducteurs, le plus souvent du silicium cristallin ou amorphe. Un élément photosensible comporte au moins une photodiode, un phototransistor ou une photorésistance. Cet élément photosensible est monté entre un conducteur de colonne et un conducteur de ligne afin d'être adressé. Les conducteurs et les éléments photosensibles sont déposés sur un substrat isolant de préférence du verre.

L'ensemble est recouvert, de manière classique dans le domaine des semi-conducteurs, d'une couche de passivation qui est destinée notamment à protéger le capteur de l'humidité. Cette couche est généralement en nitrure de silicium ou en oxyde de silicium.

On prend pour exemple le domaine de l'imagerie à rayons X avec comme convertisseur un écran scintillateur. En fonction de l'application envisagée, différentes compositions de substances scintillatrices sont utilisées comme par exemple l'oxysulfure de gadolinium dopé au terbium (Gd₂ 0₂ S : Tb) ou encore l'iodure de césium dopé au thallium (CsI : Tl).

Le silicium cristallin ne peut être obtenu qu'en surfaces relativement faibles et sert à réaliser des capteurs photosensibles du type CCD de l'anglais « charge coupled device » soit en français « dispositif à transfert de charges ». Ces capteurs photosensibles de type CCD sont plus particulièrement utilisés dans le cadre de l'imagerie dentaire ou en mammographie.

Le silicium amorphe hydrogéné permet de réaliser des capteurs photosensibles de plus grandes dimensions (pouvant atteindre par exemple 50 cm x 50 cm). Il est utilisé généralement à l'aide de techniques de dépôt de films en couches minces, pour constituer des matrices de photodiodes ou de phototransistors. Ces matrices de détection, de dimensions variables, sont applicables à l'ensemble des domaines de la radiologie classique.

De tels détecteurs de rayonnement utilisant l'association d'un écran scintillateur et d'un capteur photosensible en matériau semiconducteur sont bien connus, notamment par les documents indiqués ci-après : l'article «Amorphous silicon X-ray Image Sensor », par J. Chabbal et al., publié en 1996 dans la revue SPIE 2708, pages 499-510 ; l'article « Development of a high résolution, active matrix, flat panel imager with enhanced fill factor », par L.E. Antonuk et all., publié en 1997 dans la revue SPIE 3032, page 2-13 ; le brevet US 5.276.329.

On peut citer aussi la demande de brevet français FR- 2 605.166, le brevet US 5 187 369 et la demande de brevet européenne EP 0 637 084 qui décrivent une structure de détecteur de rayonnement utilisant un écran scintillateur et une matrice de photodiodes en silicium amorphe, ainsi que le fonctionnement du détecteur de rayonnement.

Le convertisseur peut être déposé directement sur le capteur photosensible. Mais il est courant de fabriquer séparément le convertisseur et le capteur photosensible et de les coupler par l'intermédiaire d'une couche de colle transparente. C'est le cas notamment lorsque le convertisseur est du type dit "écran renforçateur", en Gd₂ O₂ S : Tb par exemple. Mais c'est aussi une configuration qui s'applique au cas des écrans scintillateurs du type obtenu par évaporation, comme les scintillateurs en iodure de césium dopé au thallium CₛI : Tl, qu'il est parfois nécessaire d'élaborer séparément afin de pouvoir leur appliquer des traitements thermiques ou chimiques incompatibles avec le capteur photosensible.

Les colles habituellement utilisées sont choisies pour leurs propriétés d'adhérence mais aussi pour leur souplesse et leurs propriétés optiques. Elles doivent résister à des contraintes mécaniques car le détecteur de rayonnement doit pouvoir supporter des contraintes mécaniques : vibrations, chocs... Elles doivent aussi être transparentes à la lumière produite par le convertisseur.

Lorsque le convertisseur est élaboré séparément, il est souvent déposé sur un support par exemple une feuille d'alliage d'aluminium qui forme alors une fenêtre d'entrée pour le rayonnement à détecter. Ces alliages d'aluminium réunissent les qualités requises qui sont une faible absorption du rayonnement incident à détecter pour une épaisseur donnant une rigidité suffisante à la feuille employée, compatible avec sa manipulation. Les dimensions des feuilles sont de l'ordre de 50cm x 50cm dans le domaine de la radiologie générale. Une absorption d'environ 1% pour un support d'épaisseur de 100 micromètres exposé à un spectre classique selon la norme américaine RQA5 est satisfaisante.

Le support doit aussi supporter les températures de dépôt et de recuit du détecteur. Pour l'iodure de césium cette température est de l'ordre de 300°C. Il doit être étanche à l'humidité et enfin être d'un coût abordable.

Dans cette configuration, avec support du convertisseur conducteur électriquement, il se produit un couplage capacitif entre éléments photosensibles si le support est laissé à un potentiel flottant. Cela provoque un phénomène de diaphonie entre éléments photosensibles. Le signal que produisent les éléments photosensibles très éclairés se transmet aux éléments photosensibles voisins qui ne sont pas ou peu éclairés. Il en résulte une perte de contraste à grande distance. On a donc été amené à rendre fixe le potentiel du support conducteur par exemple en le portant à la masse ou à une autre tension plus appropriée.

Il a été constaté, dans certains cas, que cette configuration de détecteur possédait une durée de vie courte.

Il est souhaitable que de tels détecteurs de rayonnement aient une durée de vie compatible avec la durée d'amortissement des appareils de radiologie ou autre sur lesquels ils sont montés, cette durée étant proche de la dizaine d'années. Le détecteur de rayonnement représente une part importante dans le coût de l'appareil et il vaudrait mieux qu'on ne soit pas obligé de le remplacer.

Le but de l'invention est donc d'augmenter la durée de vie des détecteurs de rayonnement à l'état solide.

Les inventeurs, en observant des détecteurs de rayonnement à l'état solide hors d'usage se sont aperçus que les conducteurs et/ou les éléments photosensibles du capteur étaient corrodés.

En poussant leurs investigations, ils en ont conclu que le matériau du convertisseur se décompose partiellement à l'air ambiant et/ou à l'humidité et produit des espèces chimiques corrosives pour le capteur photosensible, ces espèces migrant, notamment sous l'effet du champ électrique entre les conducteurs et le support du capteur, vers les éléments photsensibles et les conducteurs et ce malgré la couche de passivation.

Pour améliorer la durée de vie de tels détecteurs de rayonnement, la présente invention propose donc de placer, entre le convertisseur et le capteur photosensible, une barrière d'un matériau imperméable à au moins une espèce chimique corrosive pour le capteur et susceptible d'être libérée lors d'au moins une réaction chimique au niveau du convertisseur.

Plus précisément le détecteur de rayonnement selon l'invention comporte un capteur photosensible à l'état solide associé à un convertisseur destiné à convertir un rayonnement à détecter en un rayonnement auquel est sensible le capteur photosensible. Le capteur photosensible possède un ou plusieurs éléments photosensibles reliés à des conducteurs. L'ensemble éléments photosensibles et conducteurs est recouvert d'une couche de passivation pour le protéger. Le détecteur de rayonnement comporte également entre la couche de passivation et le convertisseur, une barrière imperméable à au moins une espèce chimique corrosive pour le capteur, cette espèce chimique étant obtenue par décomposition du convertisseur, cette barrière étant dans un matériau autre que le polymide.

La réaction de décomposition susceptible de se produire est une réaction d'oxydation et/ou une réaction d'hydrolyse et/ou une réaction d'électrolyse.

De préférence, la barrière est choisie hydrophobe pour ne pas accentuer le phénomène de dégradation et de migration et ne pas attaquer le capteur si elle est déposée directement sur lui.

La barrière a un indice de réfraction aussi proche que possible de celui de la couche de passivation.

On s'arrange pour que la barrière épouse fidèlement la surface sur laquelle elle est déposée notamment si cette surface comporte des reliefs.

Si la barrière possède un fondement suffisament plan, elle peut comporter en surface une couche de protection inerte chimiquement, à base par exemple de fluorure,

La barrière peut être réalisée à base de résine telle qu'une résine acrylique, ou une résine dérivée du benzo-cyclo-butène.

On peut choisir aussi un élastomère silicone bi-composant contenant le moins possible de solvant après polymérisation.

La barrière peut être réalisée à base de polyparaxylène ou d'un de ses dérivés halogénés, tel que le polytétrafluoroparaxylène.

On peut aussi choisir un vernis tropicalisant, un sol-gel d'au moins un composé minéral tel que la silice.

La barrière peut être réalisée à partir d'une solution à base de silicate soluble ou à partir d'au moins une membrane polyester collée.

Du carbone diamant déposé en phase vapeur donne aussi de bons résultats.

Pour augmenter encore la protection, il est préférable que la barrière soit formée d'un empilement de couches.

L'invention sera mieux comprise et d'autres caractéristiques et avantages apparaîtront à la lecture de la description qui suit d'exemples de détecteur de rayonnement à l'état solide en référence aux figures annexées parmi lesquelles :
- la figure 1 montre en coupe un détecteur de rayonnement classique permettant d'expliquer les phénomènes de destruction du capteur photosensible à l'état solide ;
- la figure 2 montre en coupe un détecteur de rayonnement selon l'invention dans lequel le capteur photosensible et le convertisseur de rayonnement sont assemblés par collage ;
- la figure 3 montre en coupe un détecteur de rayonnement selon l'invention avec couche de protection supplémentaire ;
- la figure 4 montre en coupe, une variante d'un détecteur de rayonnement selon l'invention dans lequel le capteur photosensible et le convertisseur de rayonnement sont assemblés par collage ;
- la figure 5 montre, en coupe, un détecteur de rayonnement selon l'invention sans couche de colle pour l'assemblage du capteur avec le convertisseur.

Sur ces figures les mêmes éléments portent la même référence.

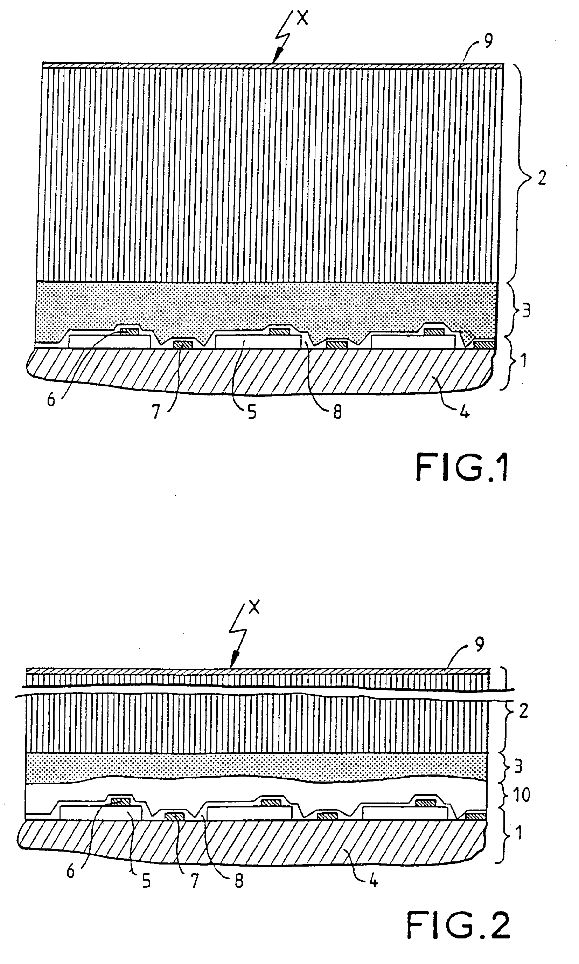

On se réfère à la figure 1. Un détecteur de rayonnement à l'état solide classique comporte un capteur 1 photosensible à l'état solide associé à un convertisseur 2. Dans l'exemple, le capteur 1 et le convertisseur 2 sont fixés l'un de l'autre à l'aide de colle 3 qui réalise aussi un couplage optique.

Le capteur 1 photosensible à l'état solide comporte sur un substrat isolant 4 généralement en verre, des éléments photosensibles 5 généralement réalisés par des photodiodes, phototransistors ou photorésistances reliés d'une part à des conducteurs de colonnes 6 et d'autre part à des conducteurs de lignes 7. Sur la figure 1, la connexion entre le conducteur de ligne 7 et l'élément photosensible 5 n'est pas visible car elle se fait à un endroit qui ne se trouve pas dans le plan de coupe.

Les éléments photosensibles 5 et leurs conducteurs de colonnes 6 et de lignes 7 sont recouverts d'une même couche de passivation 8 qui les protège notamment de l'humidité. Les éléments photosensibles en silicium amorphe sont très sensibles à l'humidité qui augmente les courants de fuite.

Dans l'exemple représenté, on suppose que le détecteur de rayonnement est un détecteur d'images radiologiques et qu'il est destiné à être exposé à des rayons X.

Le convertisseur 2 est alors un écran scintillateur par exemple en oxysulfure de terres rares ou en iodure de césium. On suppose qu'il a été déposé sur un support 9 conducteur.

Comme on l'a déjà dit, les inventeurs se sont aperçus que de tels convertisseurs 2 se dégradaient de manière inévitable à l'air et/ou à l'humidité.

Les méfaits dus à l'air ambiant sont difficiles à supprimer, quant à l'humidité, la colle utilisée en contient souvent des traces à cause soit encore de l'air ambiant soit du processus de polymérisation s'il s'agit de colles polymères.

Si l'écran scintillateur est en oxysulfure de terres rares la décomposition est une hydrolyse et il se dégage du sulfure d'hydrogène chimiquement très agressif. Par exemple la réaction avec l'oxysulfure de lanthane est la suivante :

La₂ O₂ S + H₂O → La₂ O₃ + H₂ S

Si l'écran scintillateur est en iodure de césium sa décomposition donne de l'hydroxyde de césium Cs⁺OH⁻ et de l'iode libre I₂ qui peut ensuite se combiner avec des ions iodures pour former le complexe I₃⁻ La réaction est la suivante :

2CsI + 1/2 O₂ + H₂O → 2Cs⁺OH⁻ + I₂

I₂ + I⁻ + 1/2O₂ + H₂O → I₃⁻ + 2 OH⁻

Les inventeurs se sont aperçus que la couche de passivation 8 présente de manière quasi inévitable des défauts tels que des fissures notamment au niveau des marches existant entre les éléments photosensibles 5 et les électrodes de colonnes 6, entre les électrodes de lignes 7 et le substrat 4. Les espèces chimiques ainsi libérées vont attaquer la couche de passivation 8 au niveau de ces défauts, puis arriver jusqu'aux éléments photosensibles 5 et jusqu'aux conducteurs 6, 7 qu'ils détruisent.

Si le convertisseur 2 a été déposé sur un support conducteur 9 et qu'en fonctionnement, ce support 9 est porté à un potentiel fixe Vₛ inférieur à celui V_{L} des conducteurs de lignes 7 et/ou à celui Vc des conducteurs de colonnes 6, la corrosion se produit beaucoup plus rapidement.

En effet un champ électrique variable apparaît dans le convertisseur 2 et il s'amorce un phénomène d'électrolyse si de l'humidité est présente. Les ions négatifs par exemple OH⁻, I⁻, I₃⁻ libérés lors de la décomposition de l'écran scintillateur, migrent très rapidement vers le capteur photosensible 1 et ils attaquent la couche de passivation 8 puis dissolvent les éléments photosensibles 5 et les conducteurs 6, 7.

Quand aux ions positifs Cs⁺ ils migrent rapidement vers le support 9 et ils provoquent une augmentation du pH capable de le trouer.

Si le potentiel V_{S} est supérieur au potentiel V_{L} ou au potentiel Vc la migration des ions se fait en sens inverse mais la corrosion existe quand même.

La figure 2 montre le même type de détecteur de rayonnement qu'à la figure 1, mais conformément à l'invention il est pourvu d'une barrière 10 imperméable à au moins une espèce chimique libérée lors d'au moins une réaction chimique de décomposition susceptible de se produire au niveau du convertisseur 2, cette barrière étant dans un matériau autre que le polymide. Cette barrière 10 est située entre la couche de passivation 8 du capteur 1 et le convertisseur 2. La réaction peut être une réaction d'oxydation et/ou d'hydrolyse et/ou d'électrolyse.

Dans l'exemple, le convertisseur 2 et le capteur 1 sont assemblés par collage, la couche de colle est référencée 3. La barrière 10 se trouve entre la couche de passivation 8 du capteur 1 et la couche 3 de colle.

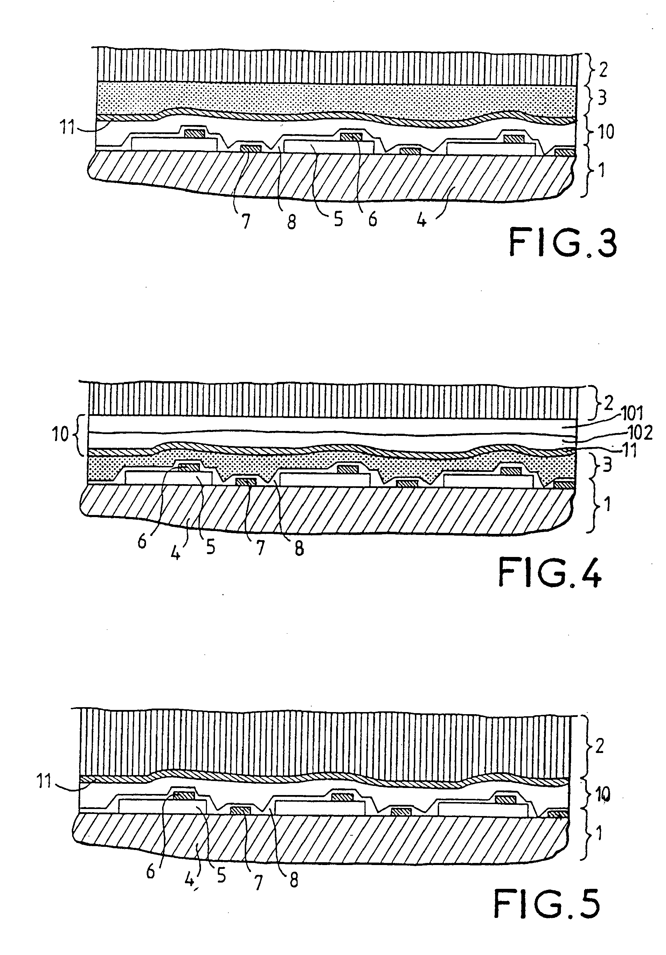

L'inverse est possible, comme illustré à la figure 4, où la barrière 10 se trouve entre le convertisseur 2 et la couche de colle 3.

La barrière 10, en plus de son imperméabilité aux espèces chimiques corrosives provenant du convertisseur 2 aura de préférence une bonne transparence à la lumière produite par le convertisseur 2. Son indice de réfraction sera aussi proche que possible de celui de la couche de passivation 8 qui est de l'ordre de 1,8 s'il s'agit de nitrure de silicium. La barrière 10 lorsqu'elle est déposée directement sur le capteur photosensible 1 est choisie inerte vis à vis de lui. Dans l'exemple décrit, s'il s'agit d'un capteur en silicium amorphe, la barrière 10 sera particulièrement hydrophobe.

On réalisera la barrière 10 à base de matériaux dont l'élaboration est compatible avec la technologie du capteur photosensible. Si ce dernier est en silicium amorphe, la barrière 10 ne doit pas libérer de solvants, ne doit pas se charger électrostatiquement.

Pour garantir un barrage fiable aux espèces chimiques libérées, il est souhaitable que la barrière 10 épouse particulièrement bien la surface sur laquelle est déposée, c'est à dire qu'elle en recouvre tous les reliefs. Ici, elle est déposée sur la couche de passivation 8 et elle doit recouvrir les flancs des marches formées par les éléments photosensibles 5, les conducteurs de colonnes 6 et de lignes 7.

Pour éviter un couplage capacitif entre différents éléments photosensibles 5, on donne à la barrière 10 une grande résistivité par exemple supérieure à 10⁶ ohms par carrés.

De manière classique, le bord du capteur photosensible 1 comporte des contacts (non représentés) aux extrémités des conducteurs de lignes 7 et de colonnes 6 de manière que ces derniers puissent être adressés. La barrière 10 doit donc être réalisée à base de matériaux compatibles avec la réalisation des contacts. Par exemple, elle doit pouvoir être déposée au masque ou doit pouvoir être gravée.

Des matériaux qui conviennent sont par exemple des résines telles que les résines acryliques, ou les résines dérivées du benzo-cyclo-butène (BCB). De telles résines peuvent être déposées à la tournette, par sérigraphie, au rouleau, par pulvérisation.

Des élastomères silicones bi-composants contenant, après polymérisation, un taux de solvant aussi faible que possible conviennent également. On les dépose en couche mince. Ceux sous forme de gel ne peuvent être employés car ils sont peu réticulés et possèdent un grand nombre de lacunes qui favorisent la migration des espèces chimiques.

Une catégorie de matériau très intéressante est le polyparaxylène ou ses dérivés halogénés tels que le polytétrafluoroparaxylène. Ces matériaux peuvent être déposés en phase vapeur et donnent des résultats particulièrement satisfaisants au point de vue recouvrement des reliefs.

On peut aussi faire appel à des vernis tropicalisants qui sont très hydrophobes.

Des composés minéraux sous forme de sol-gel, notamment des composés de silice, peuvent aussi être utilisés. On les dépose par trempé et on fait sécher au four. La couche obtenue est particulièrement peu poreuse.

Des solutions à bases de silicates solubles, connues sous la dénomination de « verres liquides » peuvent aussi être employées. Leur dépôt peut se faire par pulvérisation suivi d'un recuit.

On peut aussi faire appel à au moins une membrane polyester que l'on colle. Un tel matériau est particulièrement bien imperméable mais le collage est assez délicat car il faut éviter les bulles. Quant à ses propriétés optiques, elles ne sont pas toujours optimales.

Le carbone diamant déposé en phase vapeur (connu sous la dénomination CVD pour Chemical Vapor Deposition) est aussi particulièrement intéressant car il recouvre bien les reliefs.

La liste des matériaux possibles n'est pas limitative.

Il est préférable que la barrière 10 soit formée d'un empilement de plusieurs couches 101, 102, de manière à obtenir une imperméabilité quasi totale. En effet en empilant plusieurs couches, il est peu probable que les éventuels défauts des couches 101, 102 coïncident.

Pour augmenter encore la protection du capteur photosensible 1, il est possible que la barrière 10 comporte de plus, en surface, une couche de protection 11 d'un matériau particulièrement inerte chimiquement, si la barrière 10 possède un fondement 100 suffisamment plan. Le fondement 100 de la barrière 10 de la figure 4 correspond aux couches 101, 102.

Une telle couche 11 de protection peut être réalisée à base de fluorure par exemple du fluorure de magnésium MgF₂. Le dépôt peut se faire sous vide selon une technique courante dans les traitements optiques.

Une telle couche de protection 11 déposée sous vide nécessite une base de dépôt relativement plane, car il se produit un phénomène d'ombre avec les dépôts sous vide. Si la base de dépôt possédait des reliefs en surplomb, les zones situées sous les surplombs ne seraient pas couvertes. Sur une surface plane le recouvrement est pratiquement sans défaut.

Sur la figure 3, la barrière 10 comporte la couche de protection 11. Le paraxylène et les résines dérivées du benzo-cyclo-butène procurent une planéité tout à fait appréciable.

Sur la figure 4, la barrière 10 a été déposée directement sur le convertisseur 2. Elle se trouve entre le convertisseur 2 et la colle 3. Elle possède deux couches 101, 102 empilées l'une sur l'autre et une couche de protection 11 en surface. La colle 3 se trouve entre la couche de passivation 8 du capteur 1 et la barrière 10. La couche de protection 11 en surface de la barrière 10 se trouve donc du côté de la colle 3.

Le dernier exemple représenté à la figure 5, illustre la configuration où il n'y a pas de colle. Le convertisseur 2 est déposé par évaporation directement sur la barrière 10 qui se trouve aussi en contact avec le capteur 1. La barrière 10 a été représentée dans sa configuration avec couche de protection 11, cette dernière étant du côté du convertisseur 2. Dans cette configuration, la barrière 10 doit supporter la température de dépôt du convertisseur 2 qui est de l'ordre de 300°C pour de l'iodure de césium par exemple. Dans cette configuration, elle sera inerte vis à vis du capteur 1.

## Revendications

1. Détecteur de rayonnement à l'état solide comportant un capteur photosensible (1) à l'état solide associé à un convertisseur (2) destiné à convertir un rayonnement à détecter en un rayonnement auquel est sensible le capteur photosensible (1), le capteur photosensible (1) comportant un ou plusieurs éléments photosensibles (5) reliés à des conducteurs (6, 7) et une couche de passivation (8) recouvrant les éléments photosensibles (5) et les conducteurs (6, 7) pour les protéger,
**caractérisé en ce qu'**il comporte entre la couche de passivation (8) et le convertisseur (2), une barrière (10) imperméable à au moins une espèce chimique corrosive pour le capteur (1), cette espèce chimique étant obtenue par décomposition du convertisseur (2), cette barrière (10) étant dans un matériau autre que le polyimide.

2. Détecteur de rayonnement selon la revendication 1, **caractérisé en ce que** la décomposition est une oxydation et/ou une hydrolyse et/ou une électrolyse.

3. Détecteur de rayonnement selon l'une des revendications 1 ou 2, **caractérisé en ce que** le convertisseur (2) est assemblé par collage au capteur (1), la barrière (10) se trouvant soit du côté du convertisseur (2) par rapport à la colle (3) soit du côté du capteur (1).

4. Détecteur de rayonnement selon l'une des revendications 1 ou 2, **caractérisé en ce que** le convertisseur (2) est déposé sur la barrière (10).

5. Détecteur de rayonnement selon l'une des revendications 1 à 4, **caractérisé en ce que** la barrière (10) est inerte vis à vis du capteur (1) lorsqu'elle est en contact direct avec lui.

6. Détecteur de rayonnement selon l'une des revendications 1 à 5, **caractérisé en ce que** la barrière (10) a un indice de réfraction aussi proche que possible de celui de la couche de passivation (8).

7. Détecteur de rayonnement selon l'une des revendications 1 à 6, **caractérisé en ce que** la barrière (10) est hydrophobe.

8. Détecteur de rayonnement selon l'une des revendications 1 à 7, **caractérisé en ce que** la barrière (10) épouse fidèlement la surface sur laquelle elle est déposée.

9. Détecteur de rayonnement selon l'une des revendications 1 à 8, **caractérisé en ce que** la barrière (10) est formée d'un empilement de couches (101, 102, 11).

10. Détecteur de rayonnement selon la revendication 9, **caractérisé en ce que** la barrière (10) comporte en surface une couche de protection (11) inerte chimiquement, si elle possède un fondement (100) suffisamment plan.

11. Détecteur de rayonnement selon la revendication 10, **caractérisé en ce que** la couche de protection (11) est réalisée à base de fluorure tel que le fluorure de magnésium.

12. Détecteur de rayonnement selon l'une des revendications 1 à 11, **caractérisé en ce que** la barrière (10) possède une résistivité électrique élevée très supérieure à environ 10⁶ ohms par carré.

13. Détecteur de rayonnement selon l'une des revendications 1 à 12, **caractérisé en ce que** la barrière (10) est réalisée à base de résine telle qu'une résine acrylique, une résine dérivée du benzo-cyclo-butène.

14. Détecteur de rayonnement selon l'une des revendications 1 à 12, **caractérisé en ce que** la barrière (10) est réalisée à base d'élastomère silicone bi-composant contenant le moins possible de solvant après polymérisation.

15. Détecteur de rayonnement selon l'une des revendications 1 à 12, **caractérisé en ce que** la barrière (10) est réalisée à base de polyparaxylène ou d'un de ses dérivés halogénés tel que le polytétrafluoroparaxylène.

16. Détecteur de rayonnement selon l'une des revendications 1 à 12, **caractérisé en ce que** la barrière (10) est réalisée à base d'un vernis tropicalisant.

17. Détecteur de rayonnement selon l'une des revendications 1 à 12, **caractérisé en ce que** la barrière (10) est réalisée à base d'un sol-gel d'au moins un composé minéral tel que la silice.

18. Détecteur de rayonnement selon l'une des revendications 1 à 12, **caractérisé en ce que** la barrière (10) est réalisée à partir d'une solution à base de silicate soluble.

19. Détecteur de rayonnement selon l'une des revendications 1 à 12, **caractérisé en ce que** la barrière (10) est réalisée à partir d'au moins une membrane polyester collée.

20. Détecteur de rayonnement selon l'une des revendications 1 à 12, **caractérisé en ce que** la barrière (10) est réalisée à base de carbone diamant déposé en phase vapeur.

## Patentansprüche

1. Festkörper-Strahlungsdetektor, der einen photosensiblen Festkörper-Sensor (1) in Kombination mit einem Umformer (2) aufweist, der zum Umformen einer zu detektierenden Strahlung in eine Strahlung bestimmt ist, für die der photosensible Sensor (1) sensibel ist, wobei der photosensible Sensor (1) ein oder mehrere photosensible Elemente (5), die mit Leitern (6, 7) verbunden sind, und eine Passivierungsschicht (8), die die photosensiblen Elemente (5) und die Leiter (6,7) bedeckt, um sie zu schützen, aufweist,
**dadurch gekennzeichnet, dass** er zwischen der Passivierungsschicht (8) und dem Umformer (2) eine Barriere (10) aufweist, die für mindestens eine für den Sensor (1) korrosive chemische Spezies undurchlässig ist, wobei diese chemische Spezies durch Zersetzung des Umformers (2) entsteht, wobei diese Barriere (10) aus einem anderen Material als das Polyimid ist.

2. Strahlungsdetektor nach Anspruch 1, **dadurch gekennzeichnet, dass** die Zersetzung eine Oxidation und/oder eine Hydrolyse und/oder eine Elektrolyse ist.

3. Strahlungsdetektor nach einem der Ansprüche 1 oder 2, **dadurch gekennzeichnet, dass** der Umformer (2) durch Kleben mit dem Sensor (1) verbunden ist, wobei sich die Barriere (10) entweder auf der Seite des Umformers (2) im Verhältnis zum Kleber (3) oder auf der Seite des Sensors (1) befindet.

4. Strahlungsdetektor nach einem der Ansprüche 1 oder 2, **dadurch gekennzeichnet, dass** der Umformer (2) auf der Barriere (10) aufgebracht ist.

5. Strahlungsdetektor nach einem der Ansprüche 1 bis 4, **dadurch gekennzeichnet, dass** die Barriere (10) gegenüber dem Sensor (1) inert ist, wenn sie im direkten Kontakt mit ihm ist.

6. Strahlungsdetektor nach einem der Ansprüche 1 bis 5, **dadurch gekennzeichnet, dass** die Barriere (10) einen Refraktionsindex hat, der dem der Passivierungsschicht (8) so ähnlich wie möglich ist.

7. Strahlungsdetektor nach einem der Ansprüche 1 bis 6, **dadurch gekennzeichnet, dass** die Barriere (10) hydrophob ist.

8. Strahlungsdetektor nach einem der Ansprüche 1 bis 7, **dadurch gekennzeichnet, dass** sich die Barriere (10) genau an die Fläche schmiegt, auf der sie aufgebracht ist.

9. Strahlungsdetektor nach einem der Ansprüche 1 bis 8, **dadurch gekennzeichnet, dass** die Barriere (10) aus einem Schichtstapel (101, 102, 11) gebildet ist.

10. Strahlungsdetektor nach Anspruch 9, **dadurch gekennzeichnet, dass** die Barriere (10) auf der Oberfläche eine chemisch inerte Schutzschicht (11) aufweist, wenn sie eine ausreichend ebene Basis (100) besitzt.

11. Strahlungsdetektor nach Anspruch 10, **dadurch gekennzeichnet, dass** die Schutzschicht (11) auf der Basis von Fluorid wie Magnesiumfluorid hergestellt ist.

12. Strahlungsdetektor nach einem der Ansprüche 1 bis 11, **dadurch gekennzeichnet, dass** die Barriere (10) eine erhöhte elektrische Resistivität sehr viel höher als zirka 10⁶ Ohm je Quadrat besitzt.

13. Strahlungsdetektor nach einem der Ansprüche 1 bis 12, **dadurch gekennzeichnet, dass** die Barriere (10) auf der Basis von Harz wie einem Acrylharz, einem Harz als Derivat des Benzocyclobutens hergestellt ist.

14. Strahlungsdetektor nach einem der Ansprüche 1 bis 12, **dadurch gekennzeichnet, dass** die Barriere (10) auf der Basis von Zweikomponenten-Silikonelastomer hergestellt ist, das so wenig wie möglich Lösungsmittel nach Polymerisation enthält.

15. Strahlungsdetektor nach einem der Ansprüche 1 bis 12, **dadurch gekennzeichnet, dass** die Barriere (10) auf der Basis von Polyparaxylen oder einem seiner Halogenderivate wie dem Polytetrafluorparaxylen hergestellt ist.

16. Strahlungsdetektor nach einem der Ansprüche 1 bis 12, **dadurch gekennzeichnet, dass** die Barriere (10) auf der Basis eines tropikalisierenden Lacks hergestellt ist.

17. Strahlungsdetektor nach einem der Ansprüche 1 bis 12, **dadurch gekennzeichnet, dass** die Barriere (10) auf der Basis eines Sol-Gels mindestens einer mineralischen Verbindung wie Kieselerde hergestellt ist.

18. Strahlungsdetektor nach einem der Ansprüche 1 bis 12, **dadurch gekennzeichnet, dass** die Barriere (10) aus einer Lösung auf der Basis löslichen Silikats hergestellt ist.

19. Strahlungsdetektor nach einem der Ansprüche 1 bis 12, **dadurch gekennzeichnet, dass** die Barriere (10) aus mindestens einer geklebten Polyestermembran hergestellt ist.

20. Strahlungsdetektor nach einem der Ansprüche 1 bis 12, **dadurch gekennzeichnet, dass** die Barriere (10) auf der Basis von in Dampfphase aufgebrachtem Carbon-Diamant hergestellt ist.

## Claims

1. A solid-state radiation detector comprising a solid-state photosensitive sensor (1) combined with a converter (2) for converting radiation to be detected into radiation to which the photosensitive sensor (1) is sensitive, the photosensitive sensor (1) comprising one or more photosensitive elements (5) linked to conductors (6, 7) and a passivation layer (8) covering the photosensitive elements (5) and the conductors (6, 7) in order to protect them,
**characterised in that** it comprises a barrier (10), positioned between the passivation layer (8) and the converter (2), that is impermeable to at least one chemical species corrosive for the sensor (1), this chemical species being obtained by decomposition of the converter (2), this barrier (10) being made of a material other than polyimide.

2. The radiation detector according to Claim 1, **characterised in that** the decomposition is oxidation and/or hydrolysis and/or electrolysis.

3. The radiation detector according to either of Claims 1 or 2, **characterised in that** the converter (2) is joined to the sensor (1) by adhesive bonding, the barrier (10) being located either on the same side as the converter (2) with respect to the adhesive (3) or on the same side as the sensor (1).

4. The radiation detector according to either of Claims 1 or 2, **characterised in that** the converter (2) is deposited on the barrier (10).

5. The radiation detector according to any of Claims 1 to 4, **characterised in that** the barrier (10) is inert with respect to the sensor (1) when the barrier is in direct contact with the sensor.

6. The radiation detector according to any of Claims 1 to 5, **characterised in that** the barrier (10) has a refraction index as close as possible to that of the passivation layer (8).

7. The radiation detector according to any of Claims 1 to 6, **characterised in that** the barrier (10) is hydrophobic.

8. The radiation detector according to any of Claims 1 to 7, **characterised in that** the barrier (10) fits closely against the surface on which it is deposited.

9. The radiation detector according to any of Claims 1 to 8, **characterised in that** the barrier (10) is formed from a stack of layers (101, 102, 11).

10. The radiation detector according to Claim 9, **characterised in that** the barrier (10) comprises, on the surface, a chemically inert protective layer (11) if it has a sufficiently flat foundation (100).

11. The radiation detector according to Claim 10, **characterised in that** the protective layer (11) is produced with a fluoride base such as magnesium fluoride.

12. The radiation detector according to any of Claims 1 to 11, **characterised in that** the barrier (10) has a high electrical resistivity, very much greater than approximately 10⁶ ohms per square.

13. The radiation detector according to any of Claims 1 to 12, **characterised in that** the barrier (10) is produced with a resin base such as an acrylic resin, a resin derived from benzocyclobutene.

14. The radiation detector according to any of Claims 1 to 12, **characterised in that** the barrier (10) is produced with a bi-constituent silicone elastomer base containing the least possible solvent after polymerisation.

15. The radiation detector according to any of Claims 1 to 12, **characterised in that** the barrier (10) is produced with a polyparaxylene base or a base comprising one of its halogenated derivatives such as polytetrafluoroparaxylene.

16. The radiation detector according to any of Claims 1 to 12, **characterised in that** the barrier (10) is produced with a tropicalising varnish base.

17. The radiation detector according to any of Claims 1 to 12, **characterised in that** the barrier (10) is produced with a sol-gel base of at least one mineral compound such as silica.

18. The radiation detector according to any of Claims 1 to 12, **characterised in that** the barrier (10) is produced from a soluble silicate-based solution.

19. The radiation detector according to any of Claims 1 to 12, **characterised in that** the barrier (10) is produced from at least one adhesively bonded polyester membrane.

20. The radiation detector according to any of Claims 1 to 12, **characterised in that** the barrier (10) is produced with a vapour-deposited diamond-like carbon base.
